# EUROPEAN PATENT SPECIFICATION

(11) **EP 1 642 742 B1**
(45) Date of publication and mention of the grant of the patent: **05.03.2008**
(21) Application number: 05020501.2
(22) Date of filing: 20.09.2005
(51) Int. Cl.: B41M 5/00, G03F 1/00

(54) **Ink jet recording sheet for plate-making mask film and process for producing flexographic printing plate**
Tintenstrahlaufzeichnungsblatt zur Maskenfilmherstellung und Verfahren zur Herstellung von Flexodruckformen
Feuille pour l'enregistrement par jet d'encre pour la fabrication de film de masquage et procédé pour la fabrication des plaques flexographiques

(30) Priority: 30.09.2004 JP 2004286955; 15.03.2005 JP 2005073191
(43) Date of publication of application: 05.04.2006
(73) Proprietor: Mitsubishi Paper Mills Limited, Chiyoda-ku Tokyo (JP)
(72) Inventor: Nakao, Takuya, Ichihara-shi Chiba Tokyo (JP); Yamada, Yasuo, Minato-ku Tokyo (JP)
(74) Representative: Müller-Boré & Partner Patentanwälte

(56) References cited:
- EP-A- 0 900 668
- EP-A- 0 976 571
- EP-A- 1 167 051
- US-A- 4 780 356
- US-A1- 2002 004 131
- PATENT ABSTRACTS OF JAPAN vol. 2000, no. 08, 6 October 2000 (2000-10-06) & JP 2000 135860 A (AGFA GEVAERT NV), 16 May 2000 (2000-05-16) & EP 0 992 846 A (AGFA-GEVAERT N.V; AGFA-GEVAERT) 12 April 2000 (2000-04-12)

## Description

The present invention relates to an ink jet recording sheet for plate-making mask film, which has good exposure characteristics and which presents good air release when contacted with a photosensitive resin plate under reduced pressure in a plate-making step, and a process for producing a flexographic printing plate.

Heretofore, in plate printing such as flexographic printing, it has been common to produce a printing plate by photomechanical process which is used a plate-making mask film prepared from an original copy by a silver photographic system. However, in recent years, a simple, inexpensive plate-making mask film by an ink jet recording system free from wet treatment, has been developed and used for producing a flexographic printing plate, a screen printing plate or the like.

In a process for producing a flexographic printing plate, a plate-making mask film and a photosensitive resin plate are contacted under reduced pressure, followed by exposure. At that time, there is a problem such that due to inadequate air release, air bubbles will remain to cause exposure failure, whereby the resolution of the resulting flexographic printing plate tends to be poor, or uneven transfer of a pattern is likely to result. It is considered that the size and density of irregularities on the plate-making mask film are influential over the remaining of air bubbles. Also with the plate-making mask film by an ink jet recording system, the air release between the photosensitive resin plate and the ink-receiving layer in contact therewith, is regarded to be important. Accordingly, a method of using a surface-roughening agent such as silica particles in an ink receiving layer (Patent Document 1) or a method of imparting irregularities to the surface of the ink receiving layer by applying an embossing treatment to the obtained ink jet recording medium (Patent Document 2) has been reported. However, in each method, a swellable ink receiving layer containing a water soluble resin as the main component is used as the ink receiving layer, whereby there has been a problem that drying of the ink is slow, and the water resistance of the mask film itself is low. Further, with respect to the method of using a surface roughening agent of silica particles, there is a problem that no specific study is made with respect to the surface roughness of the ink receiving layer, and it is not known whether it is possible to carry out adequate air release at the time of the contact of the plate-making mask film and the photosensitive resin plate under reduced pressure. Also by the method of forming irregularities on the surface of the ink receiving layer by embossing treatment, it was not possible to form a sufficient surface roughness of the ink receiving layer, and it was inadequate for improvement of the air release.
Patent Document 1: JP-A-2000-135860
Patent Document 2: JP-A-2002-52807

It is an object of the present invention to provide an ink jet recording sheet for plate-making mask film, which has good exposure characteristics and presents good air release when contacted with a photosensitive resin plate under reduced pressure, and a process for producing a flexographic printing plate obtained by using such a sheet.

The present invention provides an ink jet recording sheet for plate-making mask film, which comprises a substrate sheet and a porous layer formed thereon and has a total luminous transmittance of at least 70% as stipulated by JIS-K7361-1, wherein the porous layer comprises 100 parts by mass of inorganic particles selected from the group consisting of alumina, alumina hydrate, silica and a silica-alumina composite and having an average particle size of at most 250 nm, from 1 to 30 parts by mass of a binder and from 0.1 to 3 parts by mass of porous particles having an average particle size of from 4 to 15 µm, and has a thickness of from 5 to 50 µm and an Oken type smoothness of from 200 to 10,000 seconds as stipulated by J. TAPPI No. 5-2. In this documentation, the average particle size is one based on mass.

Further, the present invention provides a process for producing a flexographic printing plate, which comprises a step of carrying out ink jet recording of a pattern on the ink jet recording sheet for plate-making mask film as defined above with a black pigmented ink, to produce a plate-making mask film having an absorbance at a wavelength of 350 nm of from 3 to 5 and an Oken type smoothness of from 1,000 to 50,000 seconds as stipulated by J. TAPPI No. 5-2 at a black printed portion, and a step of contacting the obtained plate-making mask film with a photosensitive resin plate under reduced pressure, followed by exposure treatment to produce a flexographic printing plate.

According to the present invention, it is possible to obtain an ink jet recording sheet for plate-making mask film, which has a high resolution and which is excellent in air release when contacted with a photosensitive resin plate under reduced pressure in a plate-making process and free from exposure failure. Further, by the process of the present invention, it is possible to obtain a flexographic printing plate which has a high resolution and which is free from defects such as printing irregularities.

In the present invention, on a substrate sheet, a porous layer is formed which comprises 100 parts by mass of the inorganic particles, from 1 to 30 parts by mass of a binder and from 0.1 to 3 parts by mass of porous particles having an average particle size of from 4 to 15 µm. It is thereby possible to obtain a plate-making mask film having a porous layer which has proper smoothness and which is excellent in transparency, and it is preferred that air release can be carried out smoothly at the time of the contact with a photosensitive resin plate under reduced pressure.

In the present invention, the material for the substrate sheet is not particularly limited, and polyethylene terephthalate, polyolefin (such as polypropylene or polyethylene) or polycarbonate may, for example, be used.

The thickness of the substrate sheet is preferably from 50 to 300 µm. The sheet preferably has a total luminous transmittance of at least 90%. If the thickness of the sheet is less than 50 µm, the strength of the resulting plate-making mask film tends to be weak, and the operation efficiency at the time of laminating to the photosensitive resin plate is likely to deteriorate, and further, rigidity as a recording sheet tends to be inadequate, and the feedability in a printer is likely to deteriorate, such being undesirable. If the thickness of the sheet exceeds 300 µm, the sheet is not likely feeded in a printer, such being undesirable. The substrate sheet particularly preferably has a thickness of from 75 to 200 µm. Further, the substrate sheet may be subjected to various surface treatments, such as corona discharge treatment, coating for surface treatment, etc., as the case requires.

The inorganic particles are either one of inorganic particles selected from the group consisting of alumina, alumina hydrate, silica and a silica-alumina composite. As the alumina, fumed alumina is preferred, alumina hydrate, boehmite is preferred, and as the silica, colloidal silica, or synthetic fine particle silica (such as precipitated silica or fumed silica) is preferred. Further, as the silica-alumina composite, a conventional one may suitably be used. However, as the inorganic particles for the present invention, it is preferred to employ agglomerated particles composed of silica and alumina, obtained by gradually adding an aluminum salt showing acidity when dissolved in water, to a silica sol containing silica particles. The inorganic particles are particularly preferably boehmite, fumed alumina or fumed silica, from the viewpoint of the excellent ink absorptivity, fixing property and transparency of the porous layer thereby obtainable. Further, the inorganic particles are required to have an average particle size of at most 250 nm, whereby the transparency of the resulting porous layer will be good, the total luminous transmittance of the resulting recording sheet will be improved, and the exposure performance will be good. If the average particle size of the inorganic particles exceeds 250 nm, the transparency of the resulting porous layer is likely to be low, such being undesirable. The average particle size of the inorganic particles is particularly preferably from 10 to 200 nm.

The binder may, for example, be starch or its modified product, polyvinyl alcohol or its modified product, a styrene/butadiene rubber latex, a nitrile/butadiene rubber latex, hydroxycellulose, hydroxymethylcellulose, polyvinylpyrrolidone, polyacrylic acid, or polyacrylamide. Among them, polyvinyl alcohol or its modified product is preferred, since the ink absorptivity or water resistance of the resulting porous layer will be good.

In the present invention, the porous layer contains from 1 to 30 parts by mass of the binder per 100 parts by mass of the inorganic particles. It is thereby possible to obtain a porous layer which is excellent in ink absorptivity and which is less susceptible to staining due to redeposition of ink during the handling after ink jet recording. If the content of the binder is less than 1 part by mass, the mechanical strength of the porous layer is likely to be low, such being undesirable. If the content exceeds 30 parts by mass, the ink absorptivity of the resulting porous layer is likely to be low, such being undesirable. The content of the binder is particularly preferably from 3 to 15 parts by mass.

The porous layer preferably has an average pore radius of from 3 to 30 nm and a pore volume of from 0.3 to 2 cm³/g, whereby it is possible to obtain a porous layer having good ink absorptivity. The porous layer particularly preferably has an average pore radius of from 8 to 15 nm and a pore volume of from 0.5 to 1.5 cm³/g. In the present invention, the pore characteristics are preferably measured by nitrogen absorption/desorption method.

Further, the porous layer contains from 0.1 to 3 parts by mass of porous particles having an average particle size of from 4 to 15 µm, per 100 parts by mass of the inorganic particles. It is thereby possible to carry out air release sufficiently at the time of the contact with the photosensitive resin plate under reduced pressure in the production of a flexographic printing plate, and it is possible to obtain a plate-making mask film having high masking performance without pinholes. If the average particle size of the porous particles is less than 4 µm, the smoothness tends to be high, whereby air release tends to be poor, thus leading to exposure failure, such being undesirable. If the average particle size exceeds 15 µm, pinholes are likely to be formed during the ink jet recording, the contact with the photosensitive resin plate tends to be poor, a clearance is likely to be formed between the plate-making mask film and the photosensitive resin plate, and irregularities are likely to occur during the exposure, such being undesirable. Further, if the content of the porous particles is less than 0.1 parts by mass, it tends to be difficult to adjust the porous layer to proper smoothness. If the content exceeds 3 parts by mass, the total luminous transmittance of the resulting plate-making mask film is likely to be low, such being undesirable. The content of the porous particles is particularly preferably from 0.5 to 2 parts by mass.

As the porous particles, inorganic pigment particles or organic pigment particles may be used, as the case requires. The inorganic pigment particles may, for example, be alumina, silica, a silica/alumina composite, aluminosilicate, calcium carbonate, magnesium carbonate, calcium sulfate, barium sulfate, titanium oxide, zinc oxide, zinc carbonate, aluminum silicate, calcium silicate, magnesium silicate, kaolin or talc. The organic pigment particles may, for example, be a urea resin, cellulose, starch or polymethyl methacrylate. As the porous particles, silica is particularly preferred from the viewpoint of common applicability and uniformity in the particle size distribution.

The porous particles preferably have an average pore radius of from 1.5 to 50 nm and a pore volume of from 0.5 to 3 cm³/g. It is thereby possible to obtain a plate-making mask film having a good resolution free from pinholes when ink jet recording is carried out on the resulting porous layer.

In the present invention, the porous layer is required to have a thickness of from 5 to 50 µm. If the thickness of the porous layer is less than 5 µm, the ink absorptivity tends to be low, and the ink jet recording tends to be difficult, such being undesirable. If the thickness exceeds 50 µm, the transparency of the resulting porous layer tends to be low, and the adhesion strength with the substrate tends to be low, such being undesirable. The porous layer particularly preferably has a thickness of from 10 to 40 µm.

The resulting porous layer is required to have a smoothness (Oken type) of from 200 to 10,000 seconds as stipulated by J. TAPPI No. 5-2, whereby air can smoothly be released at the time of the contact with the photosensitive resin plate under reduced pressure. If the smoothness is less than 200 seconds, the adhesion with the photosensitive resin plate at the time of the contact under reduced pressure tends to be low, whereby irregularities are likely to result during the exposure, such being undesirable. If the smoothness exceeds 10,000 seconds, the air release at the time of the contact with the photosensitive resin plate under reduced pressure tends to be inadequate, and exposure failure is likely to result, such being undesirable. The porous layer particularly preferably has a smoothness (Oken type) of from 400 to 8,500 seconds.

The ink jet recording sheet for plate-making mask film, obtained by the present invention, is required to have a total luminous transmittance of at least 70% as stipulated by JIS K7361-1. If the total luminous transmittance is less than 70%, the exposure property is likely to be low, such being undesirable. The total luminous transmittance is preferably at least 80%, particularly preferably at least 90%.

For the ink jet recording sheet for plate-making mask film of the present invention, either dye-based ink or pigmented ink may be used. However, pigmented ink is particularly preferred from the viewpoint of the masking property, storage and water resistance. The pigment in the pigmented ink preferably has an average particle size of from 0.005 to 1 µm, whereby the pigment will be all deposited on the surface of the porous layer without penetrating into the interior of the porous layer having the above-mentioned pore characteristics, and a plate-making mask film having a good masking property can be obtained.

In the present invention, as a means to form the porous layer on the sheet, a conventional method may be employed. For example, a method may be mentioned wherein a slurry comprising the inorganic particles, the binder and the porous particles, is prepared, and the slurry is applied by e.g. a roll coater, an air knife coater, a blade coater, a rod coater, a bar coater, a comma.coater, a gravure coater, a die coater, a curtain coater, a spray coater or a slide coater, followed by drying. The drying method may, for example, be hot air, infrared ray or heating cylinder, as a heating system.

In the present invention, a flexographic printing plate is prepared preferably via a step of carrying out ink jet recording on the ink jet recording sheet for plate-making mask film of the present invention with a black pigmented ink, to produce a plate-making mask film having an absorbance at a wavelength of 350 nm of from 3 to 5 and a smoothness (Oken type) of from 1,000 to 50,000 seconds as stipulated by J. TAPPI No. 5-2 at a black printed portion. When the absorbance at a wavelength of 350 nm at the black printed portion is from 3 to 5, a proper amount of the pigment is maintained on the porous layer of the ink jet recording sheet for plate-making mask film, whereby the transmittance will be proper for the exposure. Further, when the smoothness of the printed portion subjected to ink jet recording with the black pigmented ink is from 1,000 to 50,000 seconds, air release can be sufficiently carried out at the time of the contact with the photosensitive resin plate under reduced pressure. If the smoothness of the black printed portion is less than 1,000 seconds, a space is likely to be formed between the printed surface and the photosensitive resin plate, and the resolution at the time of the exposure is likely to deteriorate, such being undesirable. If the smoothness exceeds 50,000 seconds, the air release may not proceed smoothly, and transferring irregularities are likely to result, such being undesirable.

By using the plate-making mask film thus obtained, a flexographic printing plate can be produced via a step of contacting the masking film with a photosensitive resin plate under reduced pressure, followed by exposure treatment. As such a photosensitive resin plate, one commonly used heretofore as a flexographic printing plate, may suitably be used. For example, it may be a solid photosensitive resin plate having an adhesive layer, a photosensitive resin layer, a protective layer, etc. laminated on a substrate film. It is preferred that such contact under reduced pressure and exposure treatment are suitably carried out by conventional methods.

Now, the present invention will be described in further detail with reference to Examples (Examples 1 to 3 and Example 8) and Comparative Examples (Examples 4 to 7). Further, in these Examples, "parts" means "parts by mass", and "%" means "mass%", unless otherwise specified. Further, the values of the pore characteristics were obtained by calculation on the basis of the measurements by AUTOSORB 3B manufactured by Quantachrome Instruments in accordance with a nitrogen absorption/desorption method.

### EXAMPLE 1

100 Parts (solid content) of alumina sol, 10 parts of polyvinyl alcohol (tradename: PVA124, manufactured by Kuraray Co., Ltd.), 0.5 part of boric acid and 0.5 part of porous silica particles (tradename: SUNSPHERE H51, manufactured by Dohkai Chemical Industries Co., Ltd., average particle size: 5 µm, average pore radius: 2.5 nm, pore volume: 1 cm³/g) were mixed to obtain a coating fluid having a solid content of 18%. This coating fluid was applied on a transparent polyethylene terephthalate film having a thickness of 100 µm by means of a die coater so that the coating thickness after drying would be 25 µm and dried at 120°C for 2 minutes to obtain an ink jet recording sheet. The porous layer of the obtained ink jet recording sheet had an average pore radius of 9 nm and a pore volume of 0.66 cm³/g.

Here, the alumina sol was prepared by the following method.

Into a glass reactor having a capacity of 2 liters, 327 g of a polyaluminum chloride aqueous solution (aluminum concentration: 23.5% as calculated as Al₂O₃, Cl concentration: 8.1%, basicity: 84% (in accordance with JIS K1475), tradename: Takibine #1500, manufactured by TAKI CHEMICAL CO., LTD.) and 1,548 g of water were charged and heated to 95°C. Then, 125 g of a commercially available sodium aluminate solution (Al₂O₃: 20%, Na₂O: 19%) was added, followed by aging for 24 hours by maintaining the liquid temperature at 95°C with stirring, to obtain a slurry. Here, the pH of the liquid immediately after addition of the sodium aluminate solution was 8.7 at 95°C. The slurry after the aging was washed by means of an ultrafiltration apparatus and then heated again to 95°C, and amidosulfuric acid was added in an amount corresponding to 2% of the total solid content of this slurry after washing, followed by concentration under reduced pressure until the total solid content became 21%, followed by ultrasonic dispersion to obtain an alumina sol having a pH of 4.5 and comprising boehmite crystal particles. Here, in the alumina sol, boehmite crystal particles were agglomerated particles and had an average particle size of 145 nm as measured by a dynamic light scattering method using a particle size measuring apparatus (type: LPA-30100, manufactured by Otsuka Electronics Co., Ltd.)

### EVALUATION METHOD

With respect to the obtained ink jet recording sheet, the following evaluation was carried out. The evaluation results are shown in Table 1. Here, with respect to the printing on the obtained ink jet recording sheet, ink jet recording was carried out by an ink jet printer (model: PX7000, manufactured by Seiko Epson Corporation) by using a black pigmented ink (tradename: PHOTOBLACK ICBk24, manufactured by Seiko Epson Corporation), to form a pattern for evaluation.

Total luminous transmittance: Measured in accordance with JIS K7361-1 using a haze meter (model: HGM-2K, manufactured by Suga Test Instruments Co., Ltd.)

Smoothness: Measured in accordance with J. TAPPI No. 5-2 using an Oken type smoothness tester (model: EYO-5-1M, manufactured by Asahi Seiko Co., Ltd., nozzle: B-1000) with respect to the ink jet recording sheet before printing and the black printed portion of the ink jet recording sheet.

Absorbance at a wavelength of 350 nm: Measured by using a spectrophotometer (model: UV2200, manufactured by Shimadzu Corporation) with respect to the black printed portion of the ink jet recording sheet.

Appearance: With respect to the black printed portion of the ink jet recording sheet, presence of pinholes was inspected. Symbol ○ indicates that no pinholes were observed, Δ indicates that pinholes were slightly observed to a practically problematic level, and × indicates that pinholes were too many to be practically useful. Further, using the ink jet recording sheet after printing, printing on a flexographic plate was carried out, and with respect to the obtained flexographic printing plate, the air release performance, and the irregularities of the printing plate were confirmed. With respect to the air release performance, symbol ○ indicates that the air release was good, and the adhesion was good, Δ indicates that the air was released, but lifting or wrinkles were observed to a practically problematic level, and × indicates that the air release was too poor to be practically useful. Further, with respect to the irregularities of the plate, symbol ○ indicates that no irregularities were observed, Δ Δ indicates that irregularities were observed to some extent, but they were practically no problematic level, and × indicates that irregularities were too much to be practically useful.

In the following Examples 2 to 8, evaluation was carried out in the same manner, and the results are shown in Table 1.

### EXAMPLE 2

An ink jet recording sheet was obtained in the same manner as in Example 1 except that the porous particles were changed to another porous silica particles (tradename: SUNSPHERE H121, manufactured by Dohkai Chemical Industries Co., Ltd., average particle size: 12 µm, average pore radius: 2.5 nm, pore volume: 1 cm³/g). The porous layer of the obtained ink jet recording sheet had an average pore radius of 9 nm and a pore volume of 0.66 cm³/g.

### EXAMPLE 3

100 Parts of fumed silica (tradename: AEROSIL 300, manufactured by Nippon Aerosil, average particle size: 14 nm), 4 parts of a polydiallylamine type cationic resin (tradename: SHALLOL DC902, manufactured DAI-ICHI KOGYO SEIYAKU CO., LTD.), 25 parts of polyvinyl alcohol, 3 parts of boric acid and 0.5 part of the same porous silica particles as in Example 1, were mixed to obtain a coating fluid having a solid content of 11%. Using this coating liquid, the operation was carried out in the same manner as in Example 1 to obtain an ink jet recording sheet. The porous layer of the obtained ink jet recording sheet had an average pore radius of 11 nm and a pore volume of 0.9 cm³/g.

### EXAMPLE 4

An ink jet recording sheet was obtained in the same manner as in Example 1 except that instead of the porous silica particles, spherical polymethyl methacrylate resin particles (tradename: MBX8, manufactured by Sekisui Plastics Co., Ltd., average particle size: 8 µm, nonporous) were used. The porous layer of the obtained ink jet recording sheet had an average pore radius of 9 nm and a pore volume of 0.66 cm³/g.

### EXAMPLE 5

An ink-jet recording sheet was obtained in the same manner as in Example 1 except that no porous silica particles were used. The porous layer of the obtained ink jet recording sheet had an average pore radius of 9 nm and a pore volume of 0.66 cm³/g.

### EXAMPLE 6

An ink jet recording sheet was obtained in the same manner as in Example 1 except that the porous particles were changed to other porous silica particles (tradename: SUNSPHERE H31, manufactured by Dohkai Chemical Industries Co., Ltd., average particle size: 3 µm, average pore radius: 2.5 nm, pore volume: 1 cm³/g). The porous layer of the obtained ink jet recording sheet had an average pore radius of 9 nm and a pore volume of 0.66 cm³/g.

### EXAMPLE 7

An ink jet recording sheet was obtained in the same manner as in Example 1 except that the porous particles were changed to other porous silica particles (tradename: SUNSPHERE H201, manufactured by Dohkai Chemical Industries Co., Ltd., average particle size: 20 µm, average pore radius: 2.5 nm, pore volume: 1 cm³/g). The porous layer of the obtained ink jet recording sheet had an average pore radius of 9 nm and a pore volume of 0.66 cm³/g.

### EXAMPLE 8

An ink jet recording sheet was obtained in the same manner as in Example 1 except that the amount of the porous silica particles was changed to 0.4 part. The porous layer of the obtained ink jet recording sheet had an average pore radius of 9 nm and a pore volume of 0.64 cm³/g.

**TABLE 1**

| | Before printing | | After printing | | | | |
|---|---|---|---|---|---|---|---|
| | Total luminous transmittance (%) | Smoothness (sec) | Absorbance | Smoothness (sec) | Pinholes | Air release | Plate irregularities |
| Example 1 | 89 | 6500 | 5 | 37000 | ○ | ○ | ○ |
| Example 2 | 90 | 560 | 5 | 1520 | ○ | ○ | ○ |
| Example 3 | 90 | 6700 | 5 | 35000 | ○ | ○ | ○ |
| Example 4 | 90 | 4500 | 5 | 35000 | Δ | ○ | ○ |
| Example 5 | 89 | More than 99999 | 5 | More than 99999 | ○ | × | × |
| Example 6 | 90 | 14800 | 5 | 78000 | ○ | × | × |
| Example 7 | 89 | 84 | 5 | 200 | × | ○ | ○ |
| Example 8 | 90 | 8400 | 5 | 48000 | ○ | ○ | ○ |

The ink jet recording sheet for plate-making mask film of the present invention is most suitable for a flexographic printing plate-making mask film.

## Claims

1. An ink jet recording sheet for plate-making mask film, which comprises a substrate sheet and a porous layer formed thereon and has a total luminous transmittance of at least 70% as stipulated by JIS-K7361-1, wherein the porous layer comprises 100 parts by mass of inorganic particles selected from the group consisting of alumina, alumina hydrate, silica and a silica-alumina composite and having an average particle size of at most 250 nm, from 1 to 30 parts by mass of a binder and from 0.1 to 3 parts by mass of porous particles having an average particle size of from 4 to 15 um, and has a thickness of from 5 to 50 µm and an Oken type smoothness of from 200 to 10,000 seconds as stipulated by J. TAPPI No. 5-2.

2. The ink jet recording sheet for plate-making mask film according to Claim 1, wherein the inorganic particles are boehmite, fumed alumina or fumed silica.

3. The ink jet recording sheet for plate-making mask film according to Claim 1 or 2, wherein the porous layer has an average pore radius of from 3 to 30 nm and a pore volume of from 0.3 to 2 cm³/g.

4. The ink jet recording sheet for plate-making mask film according to any one of Claims 1 to 3, wherein the porous particles are silica.

5. A process for producing a flexographic printing plate, which comprises a step of carrying out ink jet recording on the ink jet recording sheet for plate-making mask film as defined in any one of Claims 1 to 4 with a black pigmented ink, to produce a plate-making mask film having an absorbance at a wavelength of 350 nm of from 3 to 5 and an Oken type smoothness of from 1,000 to 50,000 seconds as stipulated by J. TAPPI No. 5-2 at a black printed portion, and a step of contacting the obtained plate-making mask film with a photosensitive resin plate under reduced pressure, followed by exposure treatment to produce a flexographic printing plate.

## Patentansprüche

1. Tintenstrahl-Aufzeichnungsblatt für Platten-erzeugenden Maskenfilm, welches ein Substratblatt und eine darauf gebildete poröse Schicht umfaßt und eine Gesamtlichtdurchlässigkeit von mindestens 70%, wie durch JIS-K7361-1 bestimmt, aufweist, wobei die poröse Schicht 100 Masse-Teile an anorganischen Teilchen, ausgewählt aus der Gruppe, bestehend aus Aluminiumoxid, Aluminiumoxidhydrat, Silica und Silica-Aluminiumoxid-Komposit, und mit einer durchschnittlichen Teilchengröße von höchstens 250 nm, von 1 bis 30 Masse-Teile eines Bindemittels und von 0,1 bis 3 Masse-Teile an porösen Teilchen mit einer durchschnittlichen Teilchengröße von 4 bis 15 µm umfasst, und eine Dicke von 5 bis 50 µm und eine Glätte vom Okentyp von 200 bis 10.000 Sekunden, wie durch J. TAPPI Nr. 5-2 bestimmt, aufweist.

2. Tintenstrahl-Aufzeichnungsblatt für Platten-erzeugenden Maskenfilm gemäß Anspruch 1, wobei die anorganischen Teilchen Boehmit, Aluminiumoxidstaub oder Quarzstaub sind.

3. Tintenstrahl-Aufzeichnungsblatt für Platten-erzeugenden Maskenfilm gemäß Anspruch 1 oder 2, wobei die poröse Schicht einen durchschnittlichen Porenradius von 3 bis 30 nm und ein Porenvolumen von 0,3 bis 2 cm³/g aufweist.

4. Tintenstrahl-Aufzeichnungsblatt für Platten-erzeugenden Maskenfilm gemäß einem der Ansprüche 1 bis 3, wobei die porösen Teilchen Silica sind.

5. Verfahren zur Herstellung einer flexographischen Druckplatte, welches einen Schritt des Durchführens von Tintenstrahlaufzeichnen auf dem Tintenstrahl-Aufzeichnungsblatt für Platten-erzeugenden Maskenfilm, wie in einem der Ansprüche 1 bis 4 definiert, mit einer schwarz pigmentierten Tinte zur Herstellung eines Platten-erzeugenden Maskenfilms mit einer Extinktion bei einer Wellenlänge von 350 nm von 3 bis 5 und einer Glätte vom Oken-Typ von 1.000 bis 50.000 Sekunden, wie durch J. TAPPI Nr. 5-2 bestimmt, an einem schwarz gedruckten Abschnitt und einen Schritt des Inkontaktbringens des erhaltenen Platten-erzeugenden Maskenfilms mit einer photoempfindlichen Harzplatte unter vermindertem Druck gefolgt von Aussetzungsbehandlung unter Herstellung einer flexographischen Druckplatte umfaßt.

## Revendications

1. Feuille pour l'enregistrement par jet d'encre pour la fabrication de film de masquage, qui comprend une feuille de substrat et une couche poreuse formée sur celle-ci et possède une transmittance lumineuse totale d'au moins 70 % selon la norme JIS-K7361-1, dans laquelle la couche poreuse comprend 100 parties en masse de particules inorganiques choisies dans le groupe constitué par l'alumine, l'hydrate d'alumine, la silice et un composite de silice-alumine et ayant une taille moyenne de particule d'au plus 250 nm, 1 à 30 parties en masse d'un liant et 0,1 à 3 parties en masse de particules poreuses ayant une taille moyenne de particule allant de 4 à 15 µm, et qui a une épaisseur allant de 5 à 50 µm et un lissé Oken allant de 200 à 10 000 secondes tel que stipulé dans J. TAPPI No. 5-2.

2. Feuille pour l'enregistrement par jet d'encre pour la fabrication de film de masquage selon la revendication 1, dans laquelle les particules inorganiques sont de la boehmite, de l'alumine sublimée ou de la silice sublimée.

3. Feuille pour l'enregistrement par jet d'encre pour la fabrication de film de masquage selon la revendication 1 ou 2, dans laquelle la couche poreuse a un rayon de pore moyen allant de 3 à 30 nm et un volume de pore allant de 0,3 à 2 cm³/g.

4. Feuille pour l'enregistrement par jet d'encre pour la fabrication de film de masquage selon l'une quelconque des revendications 1 à 3, dans laquelle les particules poreuses sont de la silice.

5. Procédé de fabrication de plaques flexographiques, qui comprend une étape consistant à réaliser l'enregistrement par jet d'encre sur la feuille d'enregistrement par jet d'encre pour la fabrication de film de masquage tel que défini selon l'une quelconque des revendications 1, à 4 avec une encre pigmentée noire, pour produire un film de masquage ayant une absorbance à une longueur d'onde de 350 nm allant de 3 à 5 et un lissé Oken allant de 1 000 à 50 000 secondes tel que stipulé dans J. TAPPI N°. 5-2 sur une partie imprimée noire, et une étape consistant à mettre en contact le film de masquage obtenu avec une plaque de résine photosensible sous pression réduite, suivie d'un traitement par exposition pour produire une plaque flexographique.
